# EUROPÄISCHE PATENTANMELDUNG

(11) **EP 0 928 634 A1**
(43) Veröffentlichungstag der Anmeldung: **14.07.1999**
(21) Anmeldenummer: 98100386.6
(22) Anmeldetag: 12.01.1998
(51) Int. Cl.: B05B 1/00, B05C 5/02

(54) **Dispensdüse für einen Die Bonder**

(71) Anmelder: ESEC SA, CH-6330 Cham/Steinhausen (CH)
(72) Erfinder: Baraldi, Luca Gino, 8047 Zürich (CH)

(57) **Zusammenfassung**

Um bei einer Vorrichtung eines Die Bonder zur Dosierung und Aufbringung einer vorbestimmten Menge eines viskosen Klebemittels, mit einer Dispensdüse, welche einen von einer Wandfläche umgebenen Zuführkanal aufweist, durch den das Klebemittel zu einer Düsenplatte leitbar ist, in der mindestens eine Austrittsöffnung vorhanden ist, wobei der Zuführkanal in die mindestens eine Austrittsöffnung mündet und im Mündungsbereich eine Querschnittsfläche des Zuführkanals grösser ist als eine Querschnittsfläche der zumindest einen Austrittsöffnung, eine bessere Entlüftung zu ermöglichen wird vorgeschlagen im Zuführkanal (7) eine Zwangsführung vorzusehen, durch welche eine Front (12) des Klebemittels beim Befüllen der Dispensdüse (2) eine vorbestimmte Strömungsrichtung erhält, so dass das Klebemittel im wesentlichen das gesamte im Zuführkanal (3) befindliche Gas in Richtung auf zumindest eine Austrittsöffnung (10, 10a) zuführt.

## Beschreibung

Die Erfindung betrifft eine Vorrichtung für einen Die Bonder zur Dosierung und Aufbringung einer vorbestimmten Menge eines viskosen Klebemittels, mit einer Dispensdüse, welche einen von einer Wandfläche umgebenen Zuführkanal aufweist, durch den das Klebemittel zu einer Düsenplatte leitbar ist, in der mindestens eine Austrittsöffnung vorhanden ist, wobei der Zuführkanal in die mindestens eine Austrittsöffnung mündet und im Mündungsbereich eine Querschnittsfläche des Zuführkanals grösser ist als eine Querschnittsfläche der zumindest einen Austrittsöffnung. Ausserdem betrifft die Erfindung eine bestimmte Verwendung der Vorrichtung.

In der Technik ist es vielfach erforderlich, eine bestimmte Menge an Flüssigkeit, zum Beispiel ein viskoses Klebemittel, dosiert abzugeben und gegebenenfalls in einem bestimmten Muster auf eine Fläche aufzubringen. Ein solcher Anwendungsfall ist beispielsweise das sogenannte 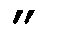 Die Bonding", bei dem elektronische Bauteile (Chips) auf ein Substrat geklebt werden. Hierzu wird mit Hilfe einer Dosiervorrichtung eines sogenannten Die Bonders eine vorbestimmte Menge an Klebemittel auf das Substrat aufgebracht. Anschliessend setzt eine Handhabungseinrichtung des Die Bonders das elektronische Bauteil auf die mit dem Klebemittel versehene Klebefläche des Substrates. Beim Hochgeschwindigkeits - Die Bonding dauert dieser Vorgang weniger als 600 ms.

Zur Dosierung des zähflüssigen Die Bonding - Klebemittels wird dieses aus einem Vorratsbehälter in einen mehr oder weniger zylinderförmigen Aufnahmebereich einer sogenannten Dispensdüse gefördert. Auf einer Abgabeseite der Düse ist mindestens eine Austrittsöffnung vorhanden, durch die das Klebemittel dosiert abgegeben wird. Es ist oftmals auch vorgesehen, dass mehrere, in einem bestimmten Muster angeordnete Austrittsöffnungen vorhanden sind, so dass ein vorbestimmtes Klebemittelmuster aufgebracht werden kann. Um eine bestimmte Menge des Klebemittels zu dosieren, wird auf das Klebemittel, beispielsweise im Vorratsbehälter, ein bestimmter Druckpuls aufgebracht. Da zwischen der erforderlichen Grösse und Dauer des Druckpulses sowie der Viskosität der Flüssigkeit, der Querschnittsfläche der Austrittsöffnung und anderen Parameter eine Abhängigkeit besteht, kann der erforderliche Druckpuls im wesentlichen vorbestimmt werden. In diesem Zusammenhang wird auf die Publikation 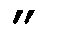 Dispensing Technology, The Key to High-quality / High Speed Die Bonding, ESEC Process Information" verwiesen, deren Inhalt hiermit durch Bezugnahme aufgenommen wird.

Es hat sich nun gezeigt, dass es immer wieder zu Diskrepanzen zwischen dem theoretisch ermittelten und dem tatsächlich erforderlichen Druckpuls kommt. Dies führt dazu, dass entweder die dosierten Flüssigkeitsmengen nicht mit den erforderlichen Mengen übereinstimmen, oder dass die Flüssigkeitsmengen nicht schnell genug aufgebracht werden können. Letzteres kann schliesslich zeitkritisch für den gesamten Prozess des Die Bonding werden und dadurch den Durchsatz beschränken.

Ausserdem tropfen vorbekannte Düsen oftmals nach, obwohl der Druckpuls längstens wieder von der Flüssigkeit genommen ist und die Flüssigkeit eine Fliessgrenze hat, aufgrund der die Flüssigkeit nicht von selbst fliessen dürfte. Da sich zu diesem Zeitpunkt die Düse des Die Bonders nicht mehr über dem Substrat befindet, kann die durch das Nachtropfen ausgestossene Flüssigkeitsmenge nicht zum Verkleben genutzt werden. Im Gegenteil, durch die nachtropfende Flüssigkeit wird die Arbeitsumgebung verschmutzt, was regelmässig zu einem Maschinenstop führt.

Der Erfindung liegt deshalb die Aufgabe zugrunde, eine Dispensdüse so weiterzubilden, dass das Nachtropfverhalten der Düsen sowie die Vorbestimmbarkeit der Parameter der erforderlichen Druckpulse verbessert werden.

Diese Aufgabe wird bei einer eingangs erwähnten Vorrichtung dadurch gelöst, dass im Zuführkanal ein Mittel zur Zwangsführung des viskosen Klebemittels vorgesehen ist, durch welche eine Front des Klebemittels beim Befüllen der Düse eine vorbestimmte Strömungsrichtung erhält, so dass das Klebemittel im wesentlichen die gesamte im Zuführkanal befindliche Luft in Richtung auf die mindestens eine Austrittsöffnung zuführt. Im Zusammenhang mit der vorliegenden Erfindung ist unter einer 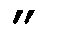 viskosen" Flüssigkeit eine Flüssigkeit zu verstehen, deren Viskosität bei Zimmertemperatur mindestens 1 Pas beträgt.

Im Rahmen der Erfindung hat es sich gezeigt, dass vielfach Gas- bzw. Lufteinschlüsse für die zuvor erwähnten Nachteile verantwortlich sind. Diese Lufteinschlüsse entstehen in der Regel während dem (erstmaligen) Befüllen der Düse, da die aus dem Vorratsbehälter in die Düse einströmende Fliessfront die Düse nur teilweise entlüften kann. Insbesondere am äusseren Umfangsbereich der Düsenplatte, in welche die Austrittsöffnungen eingebracht sind, bilden sich oftmals 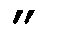 tote" Nischen (Strömungstotbereiche) aus, in denen die Flüssigkeit Luft einschliesst. Diese Lufteinschlüsse wirken bei der Aufbringung von Druckpulsen ähnlich wie ein Stossdämpfer. Zum einen speichern die Einschlüsse aufgrund der Kompression der Luft einen Teil der Energie, wodurch nicht die gesamte aufgebrachte Energie zur Ausstossung der Flüssigkeit genutzt werden kann. Zum anderen gibt die Luft am Ende des bzw. nach Beendigung des Pulses die gespeicherte Energie an die Flüssigkeit wieder in Form von kinetischer Energie ab. Es hat sich gezeigt, dass insbesondere dies eine Ursache für das nachteilige Nachtropfen der Düse ist.

Bei erfindungsgemässen Dispensdüsen werden derartige Lufteinschlüsse auf eine konstruktiv unaufwendige Weise verhindert, indem nämlich die Klebemittelfront selbst das in der Düse befindliche Gas auf die Austrittsöffnungen zuleitet. Im Zusammenhang mit der Erfindung ist unter 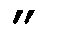 Klebemittelfront" die Oberfläche der Flüssigkeit zu verstehen, die sich beim Befüllen der Düse ausbildet und in Richtung der Düsenplatte der Düse bzw. der Austrittsöffnungen strömt. Vorteilhafterweise entlüftet die Klebemittelfront aufgrund der Zwangsführung die erfindungsgemässe Düse im wesentlichen vollständig. Selbstverständlich ist es jedoch nicht unbedingt erforderlich, dass der verbleibende Gasgehalt in der Düse tatsächlich Null ist. Um gegenüber vorbekannten Düsen Vorteile zu erzielen, ist es ausreichend, wenn die verbleibenden Lufteinschlüsse auf ein Mass zurückgeführt werden, durch die praxisrelevante Nachteile vermeidbar sind.

In Abhängigkeit von der Anzahl der Austrittsöffnungen und/oder der Verteilung der Austrittsöffnungen an der Düsenplatte kann die Zwangsführung unterschiedlich gestaltet sein. Es hat sich jedoch als zweckmässig erwiesen, wenn die Zwangsführung eine in dem Zuführkanal gegenüber der Düsenplatte angeordnete Schikane aufweist. Unter 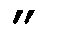 Schikane" ist ein Strömungsleitelement zu verstehen, mit dem die für den Durchfluss des Klebemittels nutzbare Querschnittsfläche des Zuführkanals verringert wird. Mit der Schikane kann das Klebemittel in der Zwangsführung zumindest abschnittsweise eine Strömungsrichtung erhalten, die von jener Strömungsrichtung abweicht, die das Klebemittel in der Zwangsführung ohne Schikane hätte.

Für viele Anwendungsfälle hat es sich als günstig erwiesen, wenn aufgrund der Zwangsführung die Flüssigkeitsfront zunächst in den Bereichen auf die Düsenplatte trifft, die den grössten Abstand zu einer Längsachse der Düsenplatte aufweisen. Anschliessend leitet die Zwangsführung das Klebemittel auf eine zentrale Längsachse bzw. die Mitte der Düsenplatte zu. Hierdurch ist es möglich, die beim Auftreffen des Klebemittels auf der Düsenplatte insgesamt im Zuführkanal noch vorhandene Luft durch das Klebemittel zu umschliessen und zu mindestens einer der Austrittsöffnungen zu leiten. Das Klebemittel kann dadurch eine Strömungsrichtung erhalten, die eine Komponente orthogonal zur Längsachse der Düsenplatte aufweist.

Weitere bevorzugte Ausgestaltungen der Erfindung ergeben sich aus den abhängigen Ansprüchen.

Die Erfindung wird anhand den in den Figuren schematisch dargestellten Ausführungsbeispielen näher erläutert; es zeigen:
- Fig. 1: eine perspektivische Teildarstellung eines Die Bonders;
- Fig. 2: eine Schnittdarstellung eines Teils einer vorbekannten Dispensdüse;
- Fig. 3: eine teilweise geschnitten dargestellte erfindungsgemässe Vorrichtung;
- Fig. 4: eine Schnittdarstellung eines Teils der erfindungsgemässen Vorrichtung aus Fig. 3;
- Fig. 5: eine Schnittdarstellung entlang der Linie V - V aus Fig. 4;
- Fig. 6: eine weitere erfindungsgemässe Vorrichtung entsprechend der Darstellung von Fig. 4.

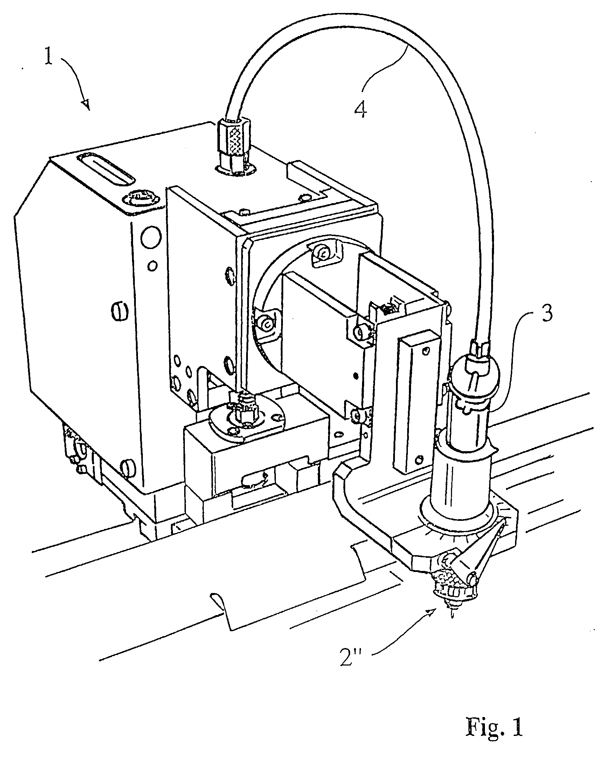

In Fig. 1 ist ein Ausschnitt eines Die Bonder 1 gezeigt, an dem erfindungsgemässe Dispensdüse eingesetzt werden können. Bei der an dem Die Bonder gezeigten Dispensdüse 2'' handelt es sich um eine an sich vorbekannte Düse mit einer einzigen Auslassöffnung. In die Dispensdüse 2'' wird aus einem Vorratsbehälter 3 ein Klebemittel eingeführt. Ein dazu erforderlicher Druck wird durch einen zeitlich und in seiner Amplitude vorbestimmten Druckluftstoss im Vorratsbehälter 3 auf das Klebemittel ausgeübt. Die hierfür benötigte Luftmenge wird über eine Leitung 4 zugeführt.

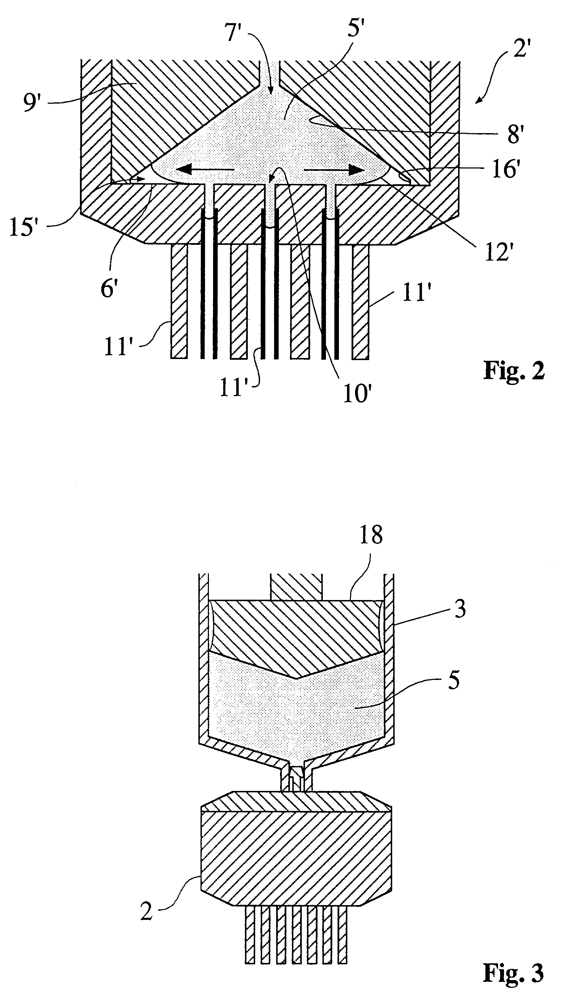

Zum besseren Verständnis der vorliegenden Erfindung wird zunächst eine in Fig. 2 näher dargestellte Dispensdüse 2' erläutert, in die aus einem nicht dargestellten Vorratsbehälter ein Klebemittel 5' eingeführt wird. Die Dispensdüse weist einen im Querschnitt kreisrunden und sich zu einer Düsenplatte 6' hin erweiternden Zuführkanal 7' auf, der durch eine im wesentlichen konische Wandfläche 8' eines Einsatzes 9' der Dispensdüse 2' gebildet wird. Der Zuführkanal 7' endet abgabeseitig an der Düsenplatte 6'. In der Düsenplatte 6' sind innerhalb einer Kreisfläche insgesamt siebzehn Austrittsöffnungen 10' eingebracht, von denen in der Darstellung von Fig. 2 sieben zu erkennen sind. In den Austrittsöffnungen 10' ist jeweils ein Dispensröhrchen 11' angeordnet.

Wie in dieser Darstellung zu erkennen ist, ist die Front 12' des Klebemittels bereits auf das Zentrum der Düsenplatte 6', d.h. auf die mit Austrittsöffnungen 10' versehene Kreisfläche der Düsenplatte 6', aufgetroffen. Da jedoch der Teil der Front 12', welcher sich zwischen den Austrittsöffnungen 10' und der Wandfläche 8' befindet, noch nicht vollständig aufgetroffen ist, hat die Front 12' bereits zwischen den Austrittsöffnungen 10' und der Wandfläche 8' Luft 15' eingeschlossen. Auch beim Weiterströmen der Front 12' kann diese Luft 15' nicht mehr entweichen und bleibt im Bereich zwischen der von der Düsenplatte 6' und der Wandfläche 8' gebildeten Kante 16' und den Austrittsöffnungen 10' eingeschlossen. Wie ohne weiteres ersichtlich ist, werden diese Lufteinschlüsse umso grösser sein, wie der Abstand der Austrittsöffnungen 10' zur Kante 16' zunimmt.

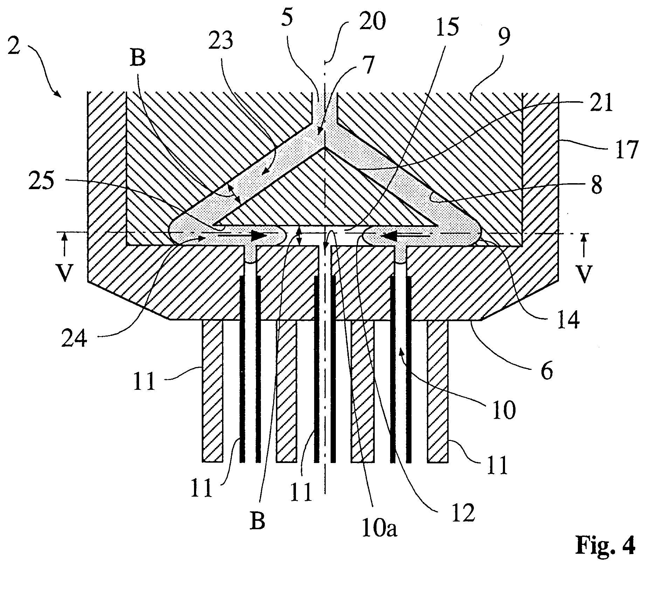

Bei dem in Fig. 3 und Fig. 4 gezeigten Ausführungsbeispiel einer erfindungsgemässen Vorrichtung, ist in einem im wesentlichen zylindrischen Gehäuse 17 einer Dispensdüse 2 ein Einsatz 9 angeordnet, in dem ein Zuführkanal 7 ausgebildet ist. Oberhalb des Zuführkanals 7 befindet sich ein mit einem Klebemittel 5 gefüllter Vorratsbehälter 3. In diesem ist ein Druckkolben 18 angeordnet, der durch eine nicht näher dargestellte Steuerung sowie durch einen entsprechenden Mechanismus des Die Bonders 1 betätigt wird. Damit ist es möglich, mit dem Kolben 18 innerhalb einer bestimmten Zeit einen bestimmten Hub auszuführen, wodurch eine vorbestimmte Menge des Klebemittels 5 in Richtung der Dispensdüse 2 gefördert werden kann.

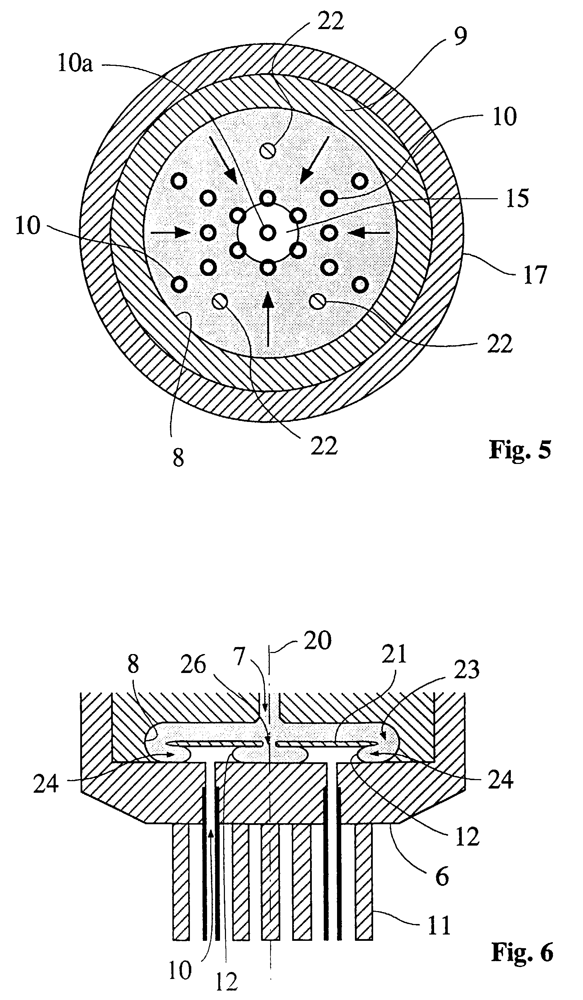

Den Fig. 3 und 4 ist weiter zu entnehmen, dass der Zuführkanal 7 der Dispensdüse 2 einen im wesentlichen kreisförmigen Querschnitt aufweist. In die - in bezug auf die Fliessrichtung des Klebemittels 5 - am Ende des Zuführkanals 7 angeordnete, ebenfalls kreisrunde Düsenplatte 6, sind mehrere Austrittsöffnungen 10 eingebracht, die in einem in etwa symmetrischen Muster zueinander angeordnet sind (vgl. auch Fig. 5). In den Austrittsöffnungen 10 befindet sich jeweils ein zylinderförmiges Dispensröhrchen 11. Insbesondere Fig. 4 und Fig. 5 verdeutlichen, dass der Zuführkanal 7 unmittelbar vor den Austrittsöffnungen 10 eine Querschnittsfläche aufweist, die weit grösser ist als eine Querschnittsfläche von jeweils einer Austrittsöffnung.

Im Zuführkanal 7 ist entlang dessen Längs- und Symmetrieachse 20 eine Schikane 21 angeordnet. Im vorliegenden Ausführungsbeispiel ist die Schikane 21 im wesentlichen als im Zuführkanal 7 konzentrisch angeordneter Kegel ausgebildet, der sich zur Düsenplatte 6 hin verbreitert. Wie insbesondere in Fig. 5 zu erkennen ist, ist die Schikane mit drei Streben 22 auf der Düsenplatte 6 befestigt.

Somit bildet sich zwischen der Schikane 21 und der Wandfläche 8 des Zuführkanals 7 einerseits sowie der Schikane 21 und der Düsenplatte 6 andererseits eine Zwangsführung für das Klebemittel aus. Diese Zwangsführung der Dispensdüse 2 weist einen im wesentlichen ringförmig in sich geschlossenen ersten Abschnitt 23 auf, der sich durch den Abstand zwischen den Wandflächen 8 des Zuführkanals 7 und der Mantelfläche der Schikane 21 ergibt. Ein zweiter Abschnitt 24 der Zwangsführung resultiert aus dem Abstand der Düsenplatte 6 zur Grundfläche 25 der Schikane 21. Im dargestellten Ausführungsbeispiel ist eine Breite B des ersten und des zweiten Abschnittes 23, 24 der Zwangsführung im wesentlichen konstant und gleich gross.

Um die anfänglich leere Dispensdüse 2 mit Klebemittel aufzufüllen, wird dieses durch eine Betätigung des Druckkolbens 18 in den Zuführkanal 7 eingeführt. Sobald das Klebemittel auf die Schikane 21 auftrifft, gelangt das Klebemittel 5 in die Zwangsführung, wodurch sich die geometrische Gestalt der Fliessfront 12 verändert. Das Klebemittel 5 strömt nun in den ersten Abschnitt 23 der Zwangsführung - und dort vor allem in unmittelbarer Nähe der kegelförmig geneigten Wandfläche 8 der Dispensdüse 2 - auf die Düsenplatte 6 zu. Am Ende des ersten Abschnittes 23 trifft das Klebemittel 5 zunächst vor allem in unmittelbarer Nähe der Wandfläche 8 des Zuführkanals 7 im Bereich des äusseren Umfangs auf die Düsenplatte 6, wodurch ein Lufteinschluss zwischen der Wandfläche 8 und dem Klebemittel 5 zumindest weitestgehend vermieden werden kann. Wie in Fig. 4 zu erkennen ist, ist der Übergang von der Wandfläche 8 zur Düsenplatte 6 aufgrund eines Radiusses 14 im wesentlichen stetig. Dies trägt dazu bei, an dieser Stelle die Ausbildung eines 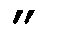 Strömungs-Totbereiches" zu verhindern, da hierdurch das Klebemittel in den zweiten Abschnitt 24 geleitet wird.

Nachdem genügend weiteres Klebemittel nachgeflossen ist, bildet sich im zweiten Abschnitt 24 der Zwangsführung eine ringförmig geschlossene Strömungsfront aus, die sowohl an der Düsenplatte 6 als auch an der Grundfläche 25 der Schikane 21 anliegt. Diese Front strömt an allen Stellen im wesentlichen gleichmässig von aussen nach innen auf die Längsachse 20 der Düsenplatte 6 zu. Mit anderen Worten, die Strömungsrichtung der Front 12 verläuft orthogonal bzw. radial in bezug auf die Längsachsen der Austrittsöffnungen 10. Hierbei schiebt die Front 12 die restliche noch in der Düse 2 befindliche Luft 15 auf die Austrittsöffnungen 10 zu.

Damit eine vollständige Entlüftung der Düse durch Austritt der Luft 15 aus den Austrittsöffnungen stattfinden kann, sollte die Zwangsführung so gestaltet sein, dass sich die ringförmige Front 12 direkt über, jedoch zumindest im Bereich einer der Austrittsöffnungen 10, schliesst. Im vorliegenden Ausführungsbeispiel schliesst sich die Front über der Austrittsöffnung 10a, die entlang der Längsachse 20 der Düse 2 verläuft. In diesem Zusammenhang ist unter 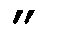 Schliessen" zu verstehen, dass sowohl eine Oberseite der Düsenplatte 6 als auch die Grundfläche 25 im wesentlichen vollständig benetzt sind. Sobald sich das Klebemittel in sämtlichen Dispensröhrchen 11 befindet, ist der Die Bonder einsatzbereit.

Selbstverständlich kann die Ausgestaltung der Schikane von der im zuvor dargestellten Ausführungsbeispiel abweichen, beispielsweise aufgrund einer anderen Verteilung der Austrittsöffnungen an der Düsenplatte oder zur Erzielung bestimmter Strömungsverhältnisse. So ist in Fig. 6 eine weitere mögliche erfindungsgemässe Variante gezeigt. Ein wesentlicher Unterschied zu dem zuvor erläuterten Ausführungsbeispiel besteht darin, dass hier die Schikane 21 in Form einer Scheibe ausgebildet ist. Da sich hier sämtliche Austrittsöffnungen 10 ausserhalb des Zentrums der Düsenplatte 6 befinden, weist die Zwangsführung in der Schikane 21 entlang der Längsachse 20 ausserdem einen zusätzlichen zentralen dritten Abschnitt 26 auf. Dieser ist in Form einer durchgehenden Ausnehmung ausgebildet, durch die das Klebemittel ebenfalls zur Düsenplatte gelangt. Somit bilden sich beim Befüllen dieser Dispensdüse zwei Strömungsfronten 12 aus, sobald das Klebemittel auf die Schikane 21 trifft.

Die eine Strömungsfront gelangt durch den hier ebenfalls vorhandenen ersten Abschnitt 23 zwischen der Wandfläche 8 des Zuführkanals und der Schikane 21 in den zweiten Abschnitt 24, in dem sie ringförmig geschlossen in Richtung auf das Zentrum der Düsenplatte 6 zuströmt. Die zweite Strömungsfront gelangt durch den dritten Abschnitt 26 auf die Düsenplatte 6 und fliesst dann im zweiten Abschnitt 24 vom Zentrum der Dusenplatte ausgehend radial nach aussen der anderen Strömungsfront entgegen.

## Patentansprüche

1. Vorrichtung für einen Die Bonder zur Dosierung und Aufbringung einer vorbestimmten Menge eines viskosen Klebemittels, mit einer Dispensdüse, welche einen von einer Wandfläche umgebenen Zuführkanal aufweist, durch den das Klebemittel zu einer Düsenplatte leitbar ist, in der mindestens eine Austrittsöffnung vorhanden ist, wobei der Zuführkanal in die mindestens eine Austrittsöffnung mündet und im Mündungsbereich eine Querschnittsfläche des Zuführkanals grösser ist als eine Querschnittsfläche der zumindest einen Austrittsöffnung, **dadurch gekennzeichnet,** dass im Zuführkanal (7) eine Zwangsführung vorgesehen ist, durch welche eine Front (12) des Klebemittels beim Befüllen der Dispensdüse (2) eine vorbestimmte Strömungsrichtung erhält, so dass das Klebemittel im wesentlichen das gesamte im Zuführkanal (3) befindliche Gas in Richtung auf zumindest eine Austrittsöffnung (10, 10a) zuführt.

2. Vorrichtung nach Anspruch 1, dadurch gekennzeichnet, dass die Zwangsführung eine im Zuführkanal (7) angeordnete Schikane (21) aufweist.

3. Vorrichtung nach einem oder beiden der vorhergehenden Ansprüche, gekennzeichnet durch Mittel der Zwangsführung, mit welchen eine Flüssigkeitsfront (12) zunächst im Bereich des Umfangs auf die Düsenplatte (6) der Dispensdüse (2) trifft und danach in Richtung des Zentrums der Düsenplatte strömt, wodurch mit der Flüssigkeitsfront (12) im wesentlichen das gesamte in der Dispensdüse befindliche Gas umschliessbar und zu der mindestens einen Austrittsöffnung (10, 10a) leitbar ist.

4. Vorrichtung nach einem oder mehreren der vorhergehenden Ansprüche, dadurch gekennzeichnet, dass in bezug auf eine Ausflussrichtung des Klebemitels aus der mindestens einen Austrittsöffnung (10, 10a) die Zwangsführung die Flüssigkeitsfront (12) im wesentlichen orthogonal zu einer Längsachse der Austrittsöffnung zuführt.

5. Vorrichtung nach einem oder mehreren der vorhergenden Ansprüche 2 bis 4, gekennzeichnet durch einen ersten Abschnitt (23) der Zwangsführung, welcher zwischen der Wand des Zuführkanals (7) und der im Zuführkanal angeordneten Schikane (21) ausgebildet ist, sowie einen zweiten Abschnitt (24) der Zwangsführung, der durch die Schikane (21) und der Düsenplatte (6) ausgebildet ist.

6. Vorrichtung nach einem oder mehreren der vorhergehenden Ansprüche 2 bis 5, dadurch gekennzeichnet, dass die Schikane (21) zumindest abschnittsweise die geometrische Gestalt eines Kegels oder einer Pyramide bzw. eines Kegel- oder Pyramidenstumpfes aufweist.

7. Vorrichtung nach einem oder beiden der vorhergehenden Ansprüche 5 und 6, gekennzeichnet durch einen dritten Abschnitt (26) der Zwangsführung, der eine Ausnehmung der Schikane aufweist.

8. Vorrichtung nach einem oder mehreren der vorhergehenden Ansprüche 2 bis 7, dadurch gekennzeichnet, dass die Schikane (21) zumindest abschnittsweise in Form einer Scheibe ausgebildet ist.

9. Verwendung der Düse gemäss einem oder mehreren der vorhergehenden Ansprüche in einer Dosiervorrichtung eines Die Bonders.
